# EUROPEAN PATENT APPLICATION

(11) **EP 4 336 262 A1**
(43) Date of publication of application: **13.03.2024**
(21) Application number: 22194304.6
(22) Date of filing: 07.09.2022
(51) Int. Cl.: G03F 7/20

(54) **METROLOGY METHOD AND ASSOCIATED METROLOGY DEVICE**

(71) Applicant: ASML Netherlands B.V., 5500 AH Veldhoven (NL)
(72) Inventor: El GAWHARY, Omar, 5500 AH Veldhoven (NL); HELFENSTEIN, Patrick, Philipp, 5500 AH Veldhoven (NL); VAN RIJSWIJK, Loes, Frederique, 5500 AH Veldhoven (NL); GEYPEN, Niels, 5500 AH Veldhoven (NL)
(74) Representative: ASML Netherlands B.V.

(57) **Abstract**

Disclosed is a method of determining at least one parameter of interest relating to a structure formed in at least one respective layer on a substrate, the method comprising: obtaining measured metrology data relating to a measurement of said structure; obtaining a model of said structure, said model describing said structure in terms of a plurality of model parameters; performing one or more first optimization steps to determine one or more vertical positional parameters of said model parameters, said one or more vertical positional parameters relating to a direction perpendicular to a substrate plane defined by a surface or interface of said substrate; and performing one or more second optimization steps subsequently to performance of said one or more first optimization steps, to determine one or more other model parameters of said plurality of model parameters.

## Description

### FIELD

The present invention relates to a metrology method and device which may, for example, be used for determining a characteristic of structures on a substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

Present reconstruction techniques, to reconstruct parameters of a structure being measured, are mathematically and computationally complex due to the number of permutations of parameters to be varied. To address this, at least in the context of overlay metrology, other overlay measurement techniques have been developed which do not require reconstruction, e.g., those based on measurements of asymmetry of targets, which are typically biased to separate the overlay asymmetry from other asymmetries.

It would be desirable to improve on such reconstruction techniques and/or overlay metrology techniques.

### SUMMARY

In a first aspect of the invention, there is provided a method of determining at least one parameter of interest relating to a structure formed in at least one respective layer on a substrate, the method comprising: obtaining measured metrology data relating to a measurement of said structure; obtaining a model of said structure, said model describing said structure in terms of a plurality of model parameters; performing one or more first optimization steps using said metrology data and model to determine one or more vertical positional parameters of said model parameters, said one or more vertical positional parameters relating to a direction perpendicular to a substrate plane defined by a surface or interface of said substrate; and performing one or more second optimization steps subsequently to performance of said one or more first optimization steps, using said metrology data and model with said one or more vertical positional parameters as determined in said one or more first optimization steps, to determine one or more other model parameters of said plurality of model parameters, said other model parameters being different to the one or more vertical positional parameters determined in the one or more first optimization steps.

According to a second aspect of the present invention there is provided a computer program product containing one or more sequences of machine-readable instructions for implementing calculating steps in a method according to the first aspect of the invention as set forth above.

The invention yet further provides a processing arrangement and metrology device comprising the computer program of the second aspect.

These and other aspects and advantages of the apparatus and methods disclosed herein will be appreciated from a consideration of the following description and drawings of exemplary embodiments.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 illustrates (a) a portion of an overlay target showing true dimensions; and (b) a model of the same overlay target comprising estimated dimensions, as used in an initial setup of a method of an embodiment;
- Figure 9 illustrates (a) the portion of an overlay target showing true dimensions as illustrated in Figure 8(a); and (b) a model of the same overlay target comprising some estimated dimensions, and dimensions determined in the first step using said method of an embodiment;
- Figure 10 illustrates (a) the portion of an overlay target showing true dimensions as illustrated in Figure 8(a); and (b) a model of the same overlay target following performance of said method of an embodiment for determining overlay; and
- Figure 11 illustrates a portion of a target structure on a stack illustrating the parameters which can be reconstructed using methods according to a further embodiment.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

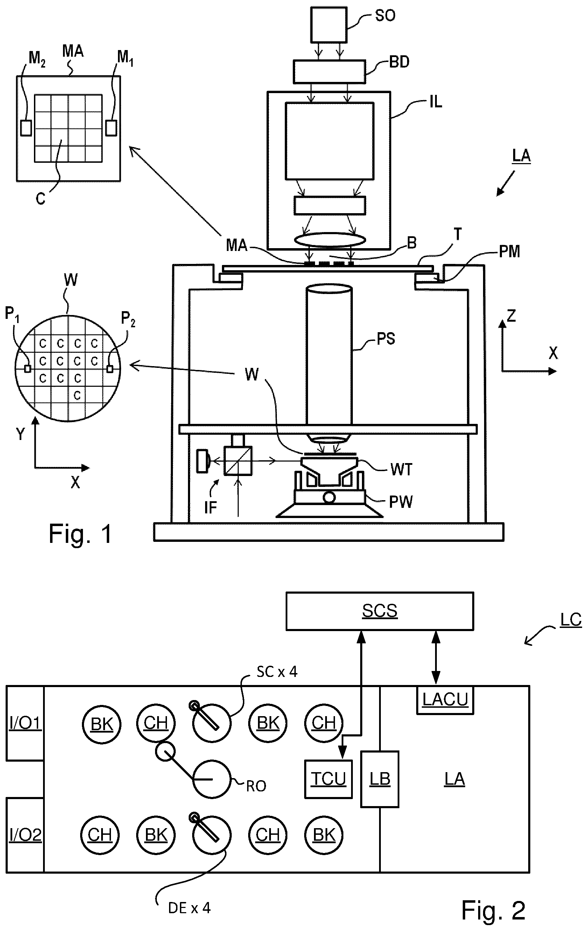

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets may behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

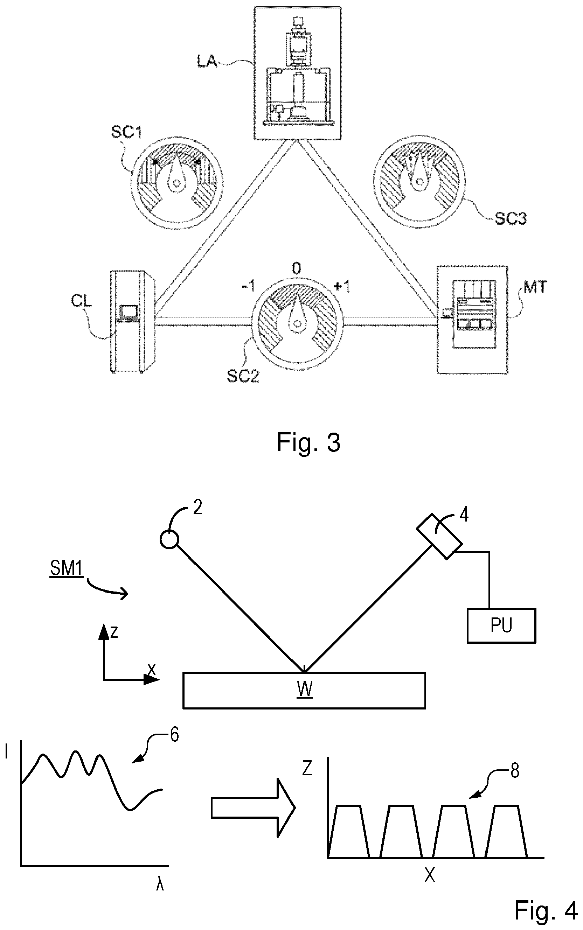

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

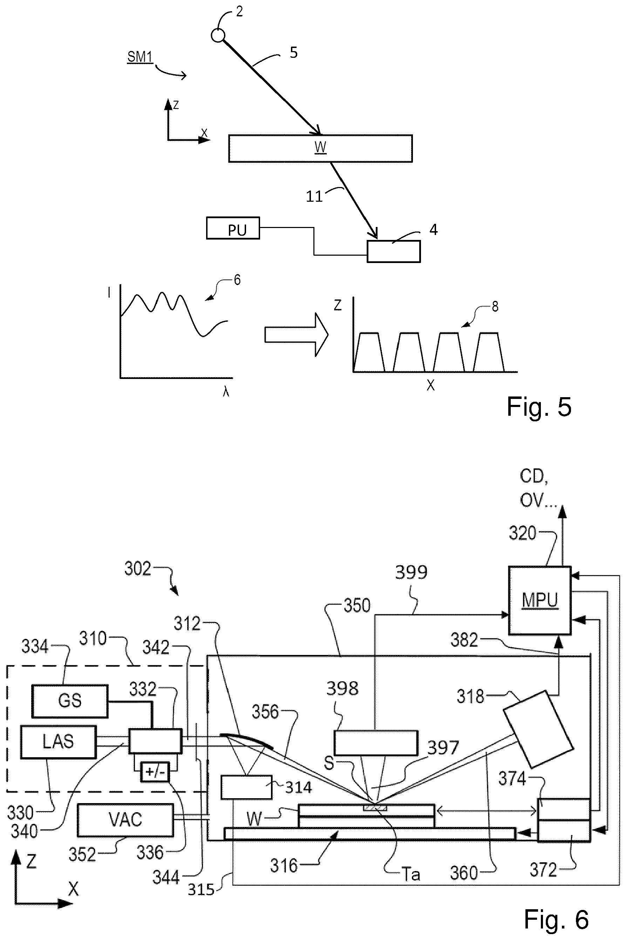

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019/003988A1, and in U.S. Patent Publication No. 2019/215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 20 nm, 1nm to 20nm or 10nm to 20nm), a source may use High Harmonic Generation (HHG) or any other types of sources mentioned above to obtain radiation at the desired wavelength(s).

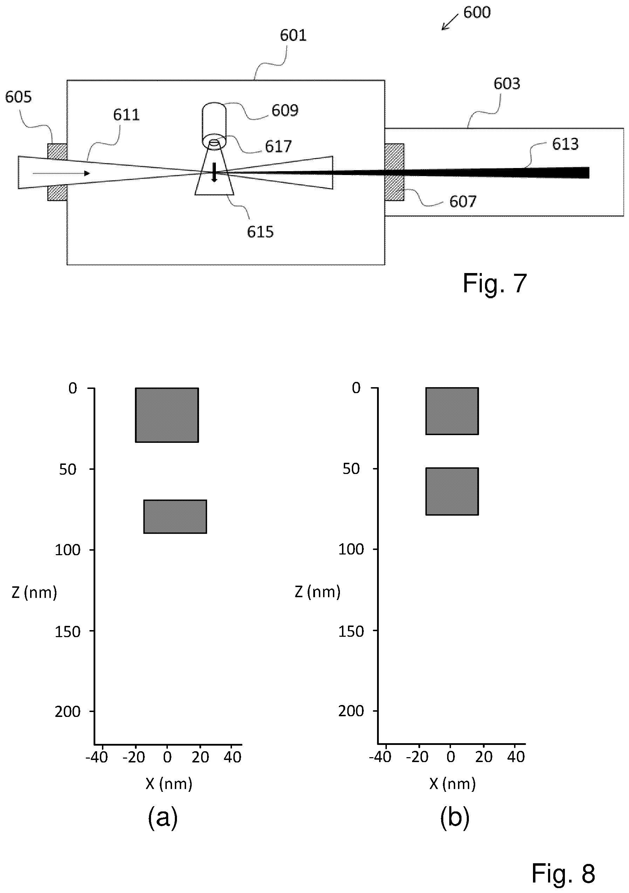

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, hereafter referred to as SXR radiation, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

In the context of overlay metrology, overlay targets usually comprise diffraction gratings (substructures) printed in different layers such that they overlap. Known overlay metrology methods infer overlay based on measurement of overlay targets with programmed biases (deliberate positional offsets between the sub-structures/gratings). Overlay metrology methods using such biased targets can obviate the need to perform a model-based reconstruction, and therefore reduces the need to know the (geometric) stack parameters between the two gratings; this information is required for known model-based reconstruction methods. This is important because stack information is often confidential and therefore not always available.

Some known metrology methods use measurement illumination within the visible wavelength band and many biased targets to set up a recipe for overlay metrology. A similar approach is also used at Soft X-Ray (SXR) wavelengths, where methods based on biased targets to train a model have been implemented.

This use of targets with multiple biases impacts yield, and such methods remain affected by grating asymmetries, stack imbalances etc.. Additionally, the use of specialized metrology targets, such as micro-diffraction based overlay (µDBO) targets or continuous diffraction based overlay cDBO targets, which are printed in the scribe lane, limits accuracy and requires additional steps to infer the overlay for product structures. Other metrology methods such as in-device metrology (IDM) addresses this latter issue, but this is at the cost of increased complexity in inferring overlay from structures having product-scale pitch. In addition, IDM metrology (at least after-develop inspection ADI; i.e., measured in resist before etching) requires a maximum layer separation between the gratings of about 50nm, which further limits the applicability of IDM.

In addition to overlay, the reconstruction of critical dimension (CD) and other geometric parameters of printed structures is becoming increasingly important for control of lithographic scanners. Photoresist profile control can be achieved using scanning electron microscopy (SEM) or transmission electron microscopy (TEM), but such techniques are slow and may be destructive to the structure being measured. As printed structures become more complex (e.g., Gate-all-around, nanosheets, forksheets) it is becoming increasingly desirable to perform such geometric parameter metrology while not requiring information on the actual stack in the target or device (which is typically unavailable).

In one embodiment, it is proposed to perform metrology in at least two main optimization steps. During the first optimization step(s), at least one vertical (or first direction) positional parameter is determined with other parameters being fixed, optionally at an estimated value. Vertical (or the first direction) in this context describes the direction perpendicular to a substrate plane, hereafter labelled the Z-direction. This step can be accomplished with high accuracy with limited prior knowledge on the target/structure. With the one or more vertical positional parameters determined, the second step can be used to determine one or more further geometric parameters of interest (e.g., a positional parameter in at least one direction perpendicular to the vertical direction, e.g., one or both directions of the substrate plane (X direction and/or Y direction). The at least one vertical parameter may describe at least one position and/or thickness of a layer or structure. One or both of the first step and second step may comprise multiple sub-steps to individually determine individual parameters or different subsets of parameters in the Z direction and the X and/or Y directions respectively. In one embodiment, during the first optimization step(s), at least one parameter, which may be a different parameter than the vertical (or first direction) positional parameter, is determined with other parameters being fixed, optionally at an estimated value.

As such, the method may comprise determining at least one parameter of interest relating to a structure formed in at least one respective layer on a substrate. Optionally the structure formed in one respective layer on the substrate. Optionally the structure formed in two respective layers on the substrate. The method comprises: obtaining measured metrology data relating to a measurement of said structure; obtaining a model of said structure, said model describing said structure in terms of a plurality of model parameters, optionally said model parameters initially comprising estimated values; performing one or more first optimization steps using said metrology data and model to determine at least one vertical positional parameter of said model parameters, said one or more vertical positional parameters relating to a direction perpendicular to a substrate plane defined by a surface or interface of said substrate, said one or more first optimization steps optimizing said one or more vertical positional parameters (e.g., optimizing only said one or more vertical positional parameters, such that the other model parameters except the one or more vertical positional parameters are fixed during this step); and performing one or more second optimization steps, using said metrology data and model with said one or more vertical positional parameters as determined in said one or more first optimization steps, to determine at least one other parameter of the model parameters such as, for example, a substrate plane positional parameter of said model parameters (the at least one substrate plane positional parameter relating to one or both directions of said substrate plane). Optionally the method comprises performing a measurement of said structure to obtain said measured metrology data. Optionally the measured metrology data has been obtained using a measurement illumination having a wavelength smaller than 100nm, smaller than 50nm, or smaller than 20nm. Optionally the measured metrology data has been obtained via a data transfer process. The model parameters may comprise one or more of dimensions, positions, layers, optical properties, profilometry parameters, orientations of the structure. Optionally the model parameters comprise model parameters of surrounding structures of the structure.

The methods described herein may use a simulation model such as a forward model to simulate both an electromagnetic interaction between incident field and target/structure and a sensor configuration (e.g., based on a physical sensor configuration or optical configuration used to capture the scattered radiation from the measured structure or target). Optionally the sensor configuration is the same as the physical sensor configuration. Optionally the sensor configuration is the same as the optical configuration used to capture the scattered radiation from the measured structure or target. The forward model may, for example, be based on the Born approximation although alternative forward models may be used.

The method may comprise comparing the measured sensor output (e.g., a diffraction pattern) and the forward model output (modelled diffraction pattern) for different model parameter values till the two outputs are well matched (e.g., according to a matching metric). As such, an optimization scheme can be used which varies one or more parameters of the model until the extremum of an appropriate cost function or merit function is found. One example of such a merit function is the cross-correlation of the calculated signal and measured signal (e.g., where the signals may be diffraction intensity of at least one diffraction order). More details of the forward model will be described later.

Soft X-ray (SXR) metrology uses simultaneous multi-wavelength measurement illumination below 100nm, below 70nm, below 50nm, below 30nm or below 20nm, e.g., in the range between 10 nm to 20 nm (or any of the ranges disclosed herein elsewhere). This inherently offers higher spatial resolution compared to visible light. At such SXR wavelengths (e.g., at least below 100nm), most materials have a refractive index close to that of vacuum. That makes the impact of multiple scattering effects, although still present, less prominent than at visible wavelengths. The inventors have determined that this allows breaking down of parameter inference problem into a set of simplified and independent sub-problems. Hence, although the approach described is a model-based overlay retrieval, it deals with a quasi model-based reconstruction because the requirements on the model are very relaxed. Essentially the only prior knowledge required is very basic knowledge on the type of structure being measured (e.g., in the first example below, the only initial knowledge requirement is that an overlay target is being measured, comprising gratings in two or more patterned layers). Actual values of other geometric and physical parameters of the stack (CDs, permittivities) can be ignored as they may not significantly impact the accuracy on the determination of the Z-interfaces (positions of the patterned layer interfaces, comprising the overlay target, in the Z-direction. In other words, the actual position of the interfaces of the patterned layers dominates the measured signal at SXR wavelengths such that those interfaces can be determined through a very simple representation of the stack, with all other parameters initially set to nominal values that can be far from the actual values.

The inventors have further determined that, at SXR wavelengths and contrary to metrology in the visible spectrum, the parameter space can be thought as factorized in sub-spaces (e.g., Z-interfaces sub-space, overlay sub-space, CDs sub-space etc.) which can be seen as mutually independent from each other. The direct consequence of this is that an optimum can be found for each sub-space independently. This leads to a great simplification of the optimization process. In fact, instead of having to optimize all parameters simultaneously (namely to search a maximum in an N-dimensional optimization problem), the problem can be split into a series of lower-dimensional problems which can each be solved independently in a step-wise approach (sequentially).

The concepts disclosed will be first described in the context of overlay inference. Methods for inferring other geometrical parameters will then be described using the same basic concept. The method according to an overlay embodiment will be described with reference to Figures 8 to 10.

Because an overlay target comprises two patterned layers (which are the two layers containing the diffraction gratings, the other layers not being patterned) it is proposed to retrieve overlay via two main sequential steps, a first step to determine the position of the Z-interfaces of the patterned layers in the stack; i.e., the positions of the layer interfaces of the patterned layers within the stack in the direction perpendicular to the substrate plane and a second step to determine the overlay.

Determining the patterned layer Z-interfaces may comprise using the forward model to find a global extremum or maximum similarity by varying the locations of the sought layer interfaces in the Z-direction, maintain all else fixed (e.g., all other modelled target parameters being maintained at an initial estimate). These interfaces may be parametrized by three undefined Z-positions, i.e., an undefined interface positions comprising the bottom Z-interface of the top grating and the top and bottom Z-interfaces of the bottom grating. The top Z-interface of the top grating may be located at Z=0 by definition, such that the other three interfaces are determined relative to this topmost interface. Of course, while this simplifies this step, the method may actively find all four Z-interfaces (e.g., should another interface be taken as reference). The Z-interfaces may be found, for example, by either employing an exhaustive search or through a local or global optimizer, depending on how much prior information is available on the target. If such prior knowledge is limited, then a global optimizer may be preferred. An exhaustive search is a brute force approach that sweeps the value of the interfaces in a forward model within given plausible ranges until it finds the best match between simulated and measured diffraction patterns.

Figure 8 illustrates the initial position at the beginning of the overlay determination. Figure 8(a) shows the ground truth (actual target geometry and overlay) and Figure 8(b) illustrates a first nominal estimate or guess. It can be appreciated that the initial guess is not accurate, and all parameters are significantly out (i.e., CDs, overlay and Z-interfaces). More specifically, in this illustrative example, the true CD values are 38 nm for both top and bottom gratings, in contrast to guessed values of 32 nm. True overlay (offset between the two gratings) is 5 nm in contrast to 0 nm in the guessed target. The target is 1D periodic along the x direction, with a pitch of 90 nm. Only one period is shown in the figures.

It is assumed that there are two patterned layers (1D periodic along the x direction) forming an overlay target. The first step may comprising sweeping over a large range of values for each of the three interfaces of the guessed target (bottom interface of the top grating and top and bottom interface of the bottom grating). For each combination of these interfaces, a simulated far-field signal is generated using the forward model which is then compared to the true signal. This is an exhaustive search, that is computationally expensive (it sweeps on a 3D space). However, using a Born approximation for example, it is an operation that can still be done in a short time (e.g., less than a minute using present common hardware). For a rigorous solver faster methods can be used.

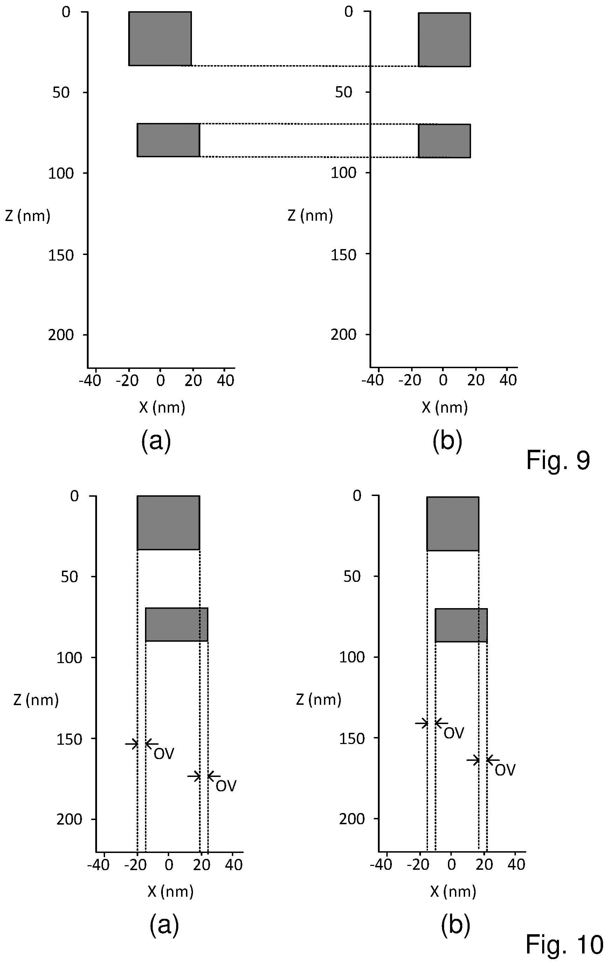

Figure 9(b) illustrates the situation after the first step has determined the Z-interfaces of the patterned layers, while Figure 9(a) again shows the ground truth for comparison and is therefore the same as Figure 8(a). The forward model is used to optimize these Z-interfaces, with all other parameters (including CDs and overlay) being fixed during this optimization. As can be seen from Figure 9(b), the positions in the stack of the Z-interfaces are accurately retrieved. The CDs and overlay are of course unchanged from the initial estimate having been fixed and, as such, remain inaccurate. Therefore, despite the modelled target having incorrect CD and overlay values, the Z-interfaces are determined largely at the correct positions. This illustrates that the model/target parameters may be treated as independent parameter sub-spaces.

Once the Z-interface values of the patterned layers are determined, overlay may be determined in the second step, by performing a further, separate, optimization using the forward model. In this optimization step, the now known z-interfaces can be fixed at their determined positions. Optionally, all other parameters can also be fixed, such that only overlay is varied during the optimization. Alternatively, the optimization may optimize overlay and one or more other parameters, such as one or both CDs, together (however this incurs a significant computational penalty and is not preferred).

The overlay optimization may be achieved by laterally shifting, within the forward model, the position of either grating (or both gratings by differing amounts), such that different overlay values (positional offsets been top and bottom gratings) are modelled. Again, the overlay value may be determined by matching the diffraction pattern from the model with the diffraction pattern actually measured over a range of overlay values.

Figure 10(b) illustrates the situation after this second step has determined overlay OV, while Figure 10(a) again shows the ground truth for comparison and is therefore the same as Figure 8(a)/9(a). The overlay OV is accurately determined using the methods disclosed, even though the CD values are still not known accurately.

What makes this approach convenient and able to work in practice, is that at SXR wavelengths, the determination of the Z-interfaces of the patterned layers is essentially insensitive to the actual grating shapes (heights, CDs etc.). This is a consequence of the above-mentioned low impact of multiple scattering effects at SXR wavelengths. More specifically, when the SXR probe beam interacts with the structure or target (e.g., an overlay target), the interaction between light and target consists of several scattering events: every point in the target is excited by the incident field and produces, in turn, a new field that adds up to the original incident field. This new field can also propagate through other parts of the target, which are now exposed not only to the original field, but also to the field having been produced by the previous scattering events within the target. This process can continue so as to form a multiple scattering process.

The importance of such higher order scattering events depends on the index of refraction of the materials involved, the wavelength of the light and the size of the target. At SXR wavelengths, while they are not negligible, they are less strong than at visible wavelengths. In addition to this, when the target comprises layers having a periodic pattern, then the periodicity of the target in those layers also imposes a periodicity on the final field scattered by the target. Because the scattered field is periodic, when it propagates away from the target and reaches the detector, it is split in discrete parts (diffraction orders) that propagate along different respective directions in space. In an SXR metrology tool, it is possible to detect some of these diffraction orders separately (e.g., such that the +1^{st} order is separated from the -1^{st} and/or the 2^{nd} orders and so on). The combination of multiple scattering and a periodic target leads to the fact that the signal of a specific diffraction order measured on the detector (e.g., a first order) results not only from the layer comprising the periodic structure, but also on other layers of the stack. How strongly these different layers perturb the main signal coming from the periodic layer depends on whether the multiple scattering is really strong (e.g., consisting of visible range wavelength(s)) or just strong (e.g., consisting of SXR range wavelength(s)). When using SXR radiation, the influence of multiple scattering exists, but is not so strong to result in the signals received from different parts of the target becoming too entangled.

As a consequence of this, when trying to retrieve the height of a diffraction grating (or layer comprising a diffraction grating), it is possible to first ignore the impact of inaccuracies on other parameters such as CDs and/or the thickness of other unpatterned layers. This physical property makes it possible to perform a step-wise reconstruction of height/Z-positions and overlay of the target.

Another, more general, method will be described to reconstruct or determine other parameters of interest of a structure or target according to the concepts disclosed herein. The specific case described in this embodiment is only an example and the method can be extended to other use cases. In this embodiment, a structure or target is assumed to comprise a 1D periodic grating on top of a multi-layered stack. During the first step of the reconstruction, the one or more vertical positional parameters determined is the height of the grating (e.g., the height of one grating feature). This step can be accomplished with high accuracy with limited prior knowledge on the target or stack below. After the height is determined, one or more other parameters may be reconstructed, such as the thickness of the layers beneath the target and/or the grating CDs, depending on the type of target and/or the required accuracy.

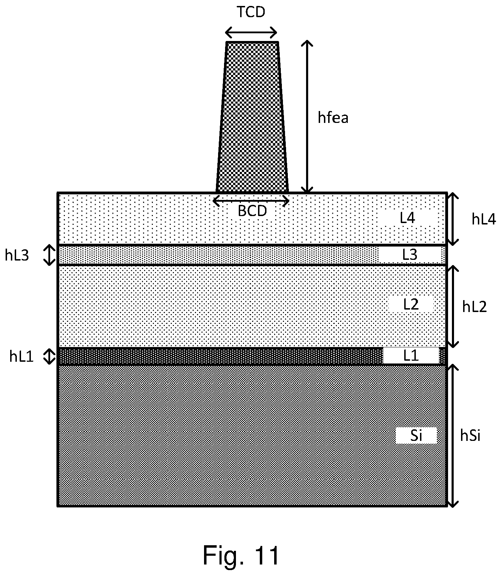

Figure 11 is a schematic drawing of an example target feature (in resist) on a number of layers. The main parameters of interest are the shape of the target feature, i.e., the feature height hfea, the top CD TCD and the bottom CD BCD. All other geometries present (e.g., the layer heights hL1-hL4 and silicon height his, which are layers below the structure) can also be determined. In one embodiment, there are more or more layers above the structure, and the geometries, optionally the layer heights of the one more more layers above the structures, can also be determined. The method may comprise retrieving the shape of the target feature by first determining the grating height, then (optionally) determining one or more of heights hL1-hL4 of layers L1-L4 (e.g., at least the height hL4 of the top layer L4). In one embodiment, the performing one or more first optimization steps comprises: determining the height of said structure; determining the height of the one or more of the layers below said structure; and repeating the step of determining the height of said structure using the determined the height of the one or more of the layers below said structure. This step can then be followed by a step of determining the CDs TCD, BCD of the feature.

As before a simulation model or forward model may be used (e.g., based on a rigorous electromagnetic solver). Using the measured sensor output (diffraction pattern), an optimization scheme may be set up that varies only the grating's height hfea in the model until the extremum of an appropriate cost function is found. No accurate prior knowledge on the target is required at this stage; all the other geometries labelled in Figure 11 may be roughly estimated. Since the optimization of this step is for only a single parameter value, an exhaustive search (e.g. a brute force approach that sweeps the value of the height within given plausible ranges until it finds the best match between simulated and measured diffraction patterns) can be used. If there is no prior knowledge available at all, then a global optimizer may be preferred to retrieve the height. Note that the feature height is actually dependent on the positions of the top and bottom of the feature; however the position of the top of the feature may be zero by definition, as in the overlay example.

Once the grating height value hfea is determined, the next parameter to retrieve may be the thickness/height of at least one of the layers (e.g., the topmost layer height hL4). In this example, the height of layer L4 (e.g., a bottom anti-reflective coating BARC) layer may be determined in this step.

Optionally, after performing this step to determine thickness of layer L4 (and/or other layers), the first step may be repeated to improve the reconstruction of the target height hfea, based on the new knowledge of the layer height(s). Because the measured signal is dominated by the target feature parameters, it may be desirable to improve on the target height hfea determination before moving to another parameter.

Once target height is determined, at least one other parameter such as a substrate plane positional parameter can be determined, e.g., such as at least one dimension (e.g., at least one CD) of said structure in one or both directions of said substrate plane. Specifically, in this example, the top CD TCD and bottom CD BCD can then be determined. This is possible only after the height of the grating has been determined with good accuracy. This step may use the forward model as has already been described, with the feature height fixed at the value determined. Additional other parameters may include one or more of any parameters relating to an angle or tilt of the structure or a part thereof, e.g., a side wall angle, hole or via angle, tilt angle, a floor tilt or other tilt.

If desired, optimizations on the thickness of one or more other layers, and/or one or more other parameters can be performed in a further optimization step.

The physical reason that this method enables a good reconstruction of height in an initial step is that the shape of the merit function (which is highly non-linear) is mostly determined by the height value hfea. In other words, the actual position of the interfaces of the patterned layers dominates the measured signal at SXR wavelengths such that those interfaces can be determined through a very simple representation of the stack, with all other parameters initially set to nominal values that can be very far from the actual values.

With regard to the optimization steps, these may be based upon using a suitable merit function. It has been observed that, when using a 1st Born approximation to electromagnetic scattering or a rigorous solver (e.g., based on integral equations solving directly the so-called Lippmann-Schwinger equation) at SXR wavelengths, the impact of height change on the measured signal is structurally different to the changes caused by a CD change. A change in height mostly causes a change in the main frequency along with a later shift of the signal observed, with the scale (amplitude) remaining substantially unchanged. By contrast, a change in CD mostly causes a change in scale of the measured signal (amplitude change), causing a negligible change in the main frequency of the signal or its later shift. Because of this observation, a merit function which is only sensitive to the main frequency and lateral shift may be used to retrieve values of the height and not CD. A suitable merit function with this property may be based on a degree of correlation between two signals, e.g., the measured and simulated signals/diffraction patterns; this may be determined as the normalized inner product between the two signals. When CDs are being determined, a different merit function which is sensitive to CD (i.e., sensitive to scale/amplitude) and largely insensitive to height (i.e., low or negligible sensitivity to the main frequency and its shift) may be used.

As such, the merit function may be chosen based on the parameter being determined at a particular step of the method. As such, ideally, a different merit function may be chosen for different parameters such that the chosen merit function is only sensitive to the change of the particular parameter being optimized for (at a particular step) and not sensitive to others parameters.

A merit function that is mostly sensitive to shift or frequency change, but not to scaling, would mostly pick height change (z-direction change or vertical positional parameter change) and not CD change. As such, the choice of the merit function can potentially reduce the number of iterations needed by the optimizer to obtain a successful reconstruction.

As such, the merit function used for each optimization in said one or more first optimization steps may comprise a high and/or maximized sensitivity to a main frequency and lateral shift of said measured metrology data and/or simulated metrology data, and a low and/or minimized sensitivity to a scale of said measured metrology data and/or simulated metrology data.

Similarly, the merit function used for each optimization in said one or more second optimization steps may comprise a high and/or maximized sensitivity to a scale of said measured metrology data and/or simulated metrology data, and a low and/or minimized sensitivity to a main frequency and lateral shift of said measured metrology data and/or simulated metrology data.

The forward model has largely been described in terms of using a Born approximation. However, any suitable electromagnetic solver (also called rigorous solver) may be used. Electromagnetic solvers differ in the manner they solve Maxwell equations and in the use case they may be suitable for. For example rigorous coupled-wave analysis (RCWA) may be used to solve Maxwell equation for periodic structures and uses an expansion of the field and permittivities in a Fourier series. Other solvers use a numerical approach (e.g., Finite Domain Time Domain FDTD) of finite element methods (FEM) or Modal Methods.

In an embodiment, it is proposed to use of a solver which solves Maxwell equations in their integral form (essentially what is called the vectorial Lipmann-Schwinger equation). However, in principle, which solver is used does not impact the results of the methods disclosed herein; only the speed of the reconstruction and its numerical accuracy and as such, any solver may be used.

In order to reduce computation time, it is optionally proposed to replace the exhaustive search for the optimum by an adaptive sampling of the merit function based on Bayesian Optimization. An important pre-condition for both approaches to converge, is the existence of a unique global extremum (i.e., no swing curve behavior) which has been observed to be true in all models when the ranges swept are below the pitch size of the structures. A Bayesian Optimization uses a global optimizer to find the global optimum (minimum or maximum) of a merit function. The optimizer may operate in the following way:
- 1) First the merit function is computed for a few values of the parameter(s) to be retrieved at that step (e.g., initial guess values). This results in the merit function having a global minimum that is to be found to be sampled at the chosen parameters.
- 2) The merit function is modelled as a Gaussian Process and the few values measured at step 1) are used to determine the next point in the parameter space where it is most convenient to observe the value of the merit function. This is determined by choosing the value which increases the level of information on the shape of the function.
- 3) Based on step 2), the merit function is updated with the new value observed; steps 2) and 3) are repeated until a global minimum is found.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. A method of determining at least one parameter of interest relating to a structure formed in at least one respective layer on a substrate, the method comprising:
   obtaining measured metrology data relating to a measurement of said structure;
   obtaining a model of said structure, said model describing said structure in terms of a plurality of model parameters;
   performing one or more first optimization steps using said metrology data and model to determine one or more vertical positional parameters of said model parameters, said one or more vertical positional parameters relating to a direction perpendicular to a substrate plane defined by a surface or interface of said substrate; and
   performing one or more second optimization steps subsequently to performance of said one or more first optimization steps, using said metrology data and model with said one or more vertical positional parameters as determined in said one or more first optimization steps, to determine one or more other model parameters of said plurality of model parameters, said other model parameters being different to the one or more vertical positional parameters determined in the one or more first optimization steps.
2. A method as claimed in clause 1, wherein said step of performing one or more first optimization steps optimizes only said one or more vertical positional parameters
3. A method as claimed in clause 1 or 2, comprising performing each said one or more first optimization steps with said model parameters fixed, except for the one or more vertical positional parameters being optimized.
4. A method as claimed in any preceding clause, wherein said one or more other parameters being determined in said one or more second optimization steps comprise one or more substrate plane positional parameters of said model parameters, said one or more substrate plane positional parameters relating to one or both directions of said substrate plane.
5. A method as claimed in any preceding clause, comprising performing each said one or more second optimization steps with said model parameters fixed, except for said one or more other parameters being determined in said one or more second optimization steps and such that said one or more vertical positional parameters are fixed at values determined in said one or more first optimization steps.
6. A method as claimed in any preceding clause, wherein each optimization step of said one or more first optimization steps and of said one or more second optimization steps each comprises comparing said measured metrology data to simulated metrology data obtained by a simulation of measurement of the structure as defined by said model.
7. A method as claimed in clause 6, wherein each optimization step comprises maximizing a similarity of the measured metrology data and simulated metrology data.
8. A method as claimed in clause 6 or 7, wherein the simulation uses a simulation model being operable to simulate an electromagnetic interaction between an incident field, the structure as defined by said model and a sensor configuration.
9. A method as claimed in clause 8, wherein said sensor configuration is based on a physical sensor configuration used to obtain said measured metrology data.
10. A method as claimed in clause 8 or 9, wherein said simulation model comprises a forward model.
11. A method as claimed in clause 8, 9 or 10, wherein said simulation model is based upon a Born approximation and/or a rigorous solver.
12. A method as claimed in any of clauses 6 to 11, comprising selecting a merit function for each said optimization step based on the model parameter being optimized at that optimization step.
13. A method as claimed in clause 12, wherein the merit function used for each optimization in said one or more first optimization steps comprises a high and/or maximized sensitivity to a main frequency and lateral shift of said measured metrology data and/or simulated metrology data, and a low and/or minimized sensitivity to a scale of said measured metrology data and/or simulated metrology data.
14. A method as claimed in clause 12 or 13, wherein the merit function used for each optimization in said one or more first optimization steps is based upon a degree of correlation between the measured metrology data and simulated metrology data.
15. A method as claimed in any of clauses 12 to 14 wherein the merit function used for each optimization in said one or more second optimization steps comprises a high and/or maximized sensitivity to a scale of said measured metrology data and/or simulated metrology data, and a low and/or minimized sensitivity to a main frequency and lateral shift of said measured metrology data and/or simulated metrology data.
16. A method as claimed in any of clauses 12 to 15, wherein one or more of said optimization steps comprises an adaptive sampling of the merit function based on Bayesian Optimization.
17. A method as claimed in any of clauses 6 to 16, wherein said measured metrology data and said simulated metrology data each comprises diffraction pattern intensity or amplitude data.
18. A method as claimed in any preceding clause, wherein:
   said structure comprises an overlay target comprising a sub-structure in respective layers of two or more patterned layers;
   said one or more vertical positional parameters comprises at least the respective positions of each undefined interface of said two patterned layers; and
   said one or more one or more other parameters being determined in said one or more second optimization steps comprises overlay in one or both directions of said substrate plane.
19. A method as claimed in clause 18, wherein said undefined interfaces comprise all interfaces of said two or more patterned layers other than the topmost interface, such that said undefined interfaces are determined relative to said topmost interface.
20. A method as claimed in any of clauses 1 to 17, wherein:
   said one or more vertical positional parameters comprises a height of said structure; and
   said one or more one or more other parameters being determined in said one or more second optimization steps comprises at least one dimension of said structure in one or both directions of said substrate plane.
21. A method as claimed in clause 20, wherein said one or more one or more other parameters being determined in said one or more second optimization steps comprises at least one critical dimension of a feature of said structure.
22. A method as claimed in clause 20 or 21, wherein said one or more one or more other parameters being determined in said one or more second optimization steps comprises a top critical dimension at the top of said feature and a bottom critical dimension at the bottom of said feature.
23. A method as claimed in clause 20, 21 or 22, wherein said one or more one or more other parameters being determined in said one or more second optimization steps comprises one or more of a side wall angle of any wall of said structure, a measure of a floor tilt of said structure and/or a measure of any other tilt of said structure.
24. A method as claimed in any of clauses 20 to 23, wherein the one or more vertical positional parameters further comprises a height of one or more of the layers below said structure.
25. A method as claimed in clause 24, wherein said performing one or more first optimization steps comprises:
   determining the height of said structure;
   determining the height of the one or more of the layers below said structure; and
   repeating the step of determining the height of said structure using the determined the height of the one or more of the layers below said structure.
26. A method as claimed in any preceding clause, comprising performing one or more further optimization steps to determine one or more of the model parameters not determined in said one or more first optimization steps or said one or more second optimization steps.
27. A method as claimed in any preceding clause, comprising performing one or more further optimization steps to further determine one or more of the model parameters determined in said one or more first optimization steps or said one or more second optimization steps.
28. A method as claimed in any preceding clause, wherein said measured metrology data has been obtained using a measurement illumination having a wavelength smaller than 100nm.
29. A method as claimed in any preceding clause, wherein said measured metrology data has been obtained using measurement illumination having a wavelength smaller than 50nm.
30. A method as claimed in any preceding clause, wherein said measured metrology data has been obtained using measurement illumination having a wavelength smaller than 20nm.
31. A method as claimed in any preceding clause, comprising performing a measurement of said structure to obtain said measured metrology data.
32. A method as claimed in any preceding clause, wherein said model parameters initially comprising estimated values.
33. A computer program comprising program instructions operable to perform the method of any preceding clause, when run on a suitable apparatus.
34. A non-transient computer program carrier comprising the computer program of clause 33.
35. A processing arrangement comprising:
   a computer program carrier comprising the computer program of clause 34; and
   a processor operable to run said computer program.
36. A metrology device comprising the processing arrangement of clause 35.
37. A metrology device being operable to perform the method as claimed in clause 31.
38. A metrology device as claimed in clause 36 or 37 comprising a scatterometer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. A method of determining at least one parameter of interest relating to a structure formed in at least one respective layer on a substrate, the method comprising:
obtaining measured metrology data relating to a measurement of said structure;
obtaining a model of said structure, said model describing said structure in terms of a plurality of model parameters;
performing one or more first optimization steps using said metrology data and model to determine one or more vertical positional parameters of said model parameters, said one or more vertical positional parameters relating to a direction perpendicular to a substrate plane defined by a surface or interface of said substrate; and
performing one or more second optimization steps subsequently to performance of said one or more first optimization steps, using said metrology data and model with said one or more vertical positional parameters as determined in said one or more first optimization steps, to determine one or more other model parameters of said plurality of model parameters, said other model parameters being different to the one or more vertical positional parameters determined in the one or more first optimization steps.

2. A method as claimed in claim 1, wherein said step of performing one or more first optimization steps optimizes only said one or more vertical positional parameters

3. A method as claimed in claim 1 or 2, comprising performing each said one or more first optimization steps with said model parameters fixed, except for the one or more vertical positional parameters being optimized.

4. A method as claimed in any preceding claim, wherein said one or more other parameters being determined in said one or more second optimization steps comprise one or more substrate plane positional parameters of said model parameters, said one or more substrate plane positional parameters relating to one or both directions of said substrate plane.

5. A method as claimed in any preceding claim, comprising performing each said one or more second optimization steps with said model parameters fixed, except for said one or more other parameters being determined in said one or more second optimization steps and such that said one or more vertical positional parameters are fixed at values determined in said one or more first optimization steps.

6. A method as claimed in any preceding claim, wherein each optimization step of said one or more first optimization steps and of said one or more second optimization steps each comprises comparing said measured metrology data to simulated metrology data obtained by a simulation of measurement of the structure as defined by said model.

7. A method as claimed in claim 6, wherein the simulation uses a simulation model being operable to simulate an electromagnetic interaction between an incident field, the structure as defined by said model and a sensor configuration.

8. A method as claimed in any preceding claim, wherein:
said structure comprises an overlay target comprising a sub-structure in respective layers of two or more patterned layers;
said one or more vertical positional parameters comprises at least the respective positions of each undefined interface of said two patterned layers; and
said one or more one or more other parameters being determined in said one or more second optimization steps comprises overlay in one or both directions of said substrate plane.

9. A method as claimed in any of claims 1 to 8, wherein:
said one or more vertical positional parameters comprises a height of said structure; and
said one or more one or more other parameters being determined in said one or more second optimization steps comprises at least one dimension of said structure in one or both directions of said substrate plane.

10. A method as claimed in any preceding claim, comprising performing one or more further optimization steps to determine one or more of the model parameters not determined in said one or more first optimization steps or said one or more second optimization steps, or to further determine the one or more of the model parameters determined in said one or more first optimization steps or said one or more second optimization steps.

11. A method as claimed in any preceding claim, wherein said measured metrology data has been obtained using a measurement illumination having a wavelength smaller than 100nm, optionally smaller than 50nm, and optionally smaller than 20nm.

12. A computer program comprising program instructions operable to perform the method of any preceding claim, when run on a suitable apparatus.

13. A non-transient computer program carrier comprising the computer program of claim 12.

14. A processing arrangement comprising:
a computer program carrier comprising the computer program of claim 13; and
a processor operable to run said computer program.

15. A metrology device comprising the processing arrangement of claim 14.
